# EUROPÄISCHE PATENTSCHRIFT

(11) **EP 3 884 549 B1**
(45) Veröffentlichungstag und Bekanntmachung des Hinweises auf die Patenterteilung: **08.04.2026**
(21) Anmeldenummer: 19808748.8
(22) Anmeldetag: 20.11.2019
(51) Int. Cl.: H01S 5/14, H01S 5/028, G02F 1/355, G02F 1/377, H01S 3/08, H01S 3/109

(54) **VORRICHTUNG ZUR ERZEUGUNG VON LASERSTRAHLUNG**
DEVICE FOR GENERATING LASER RADIATION
DISPOSITIF DE PRODUCTION D'UN RAYONNEMENT LASER

(30) Priorität: 23.11.2018 DE 102018129623
(43) Veröffentlichungstag der Anmeldung: 29.09.2021
(73) Patentinhaber: Ferdinand-Braun-Institut gGmbH, Leibniz-Institut für Höchstfrequenztechnik, 12489 Berlin (DE)
(72) Erfinder: WERNER, Nils, 10318 Berlin (DE); HOFMANN, Julian, 82110 Germering (DE); BEGE, Roland, 10243 Berlin (DE); SAHM, Alexander, 14195 Berlin (DE); PASCHKE, Katrin, 14552 Michendorf (DE)
(74) Vertreter: Gulde & Partner
(86) Internationale Anmeldenummer: PCT/EP2019/081913
(87) Internationale Veröffentlichungsnummer: WO 2020/104519

(56) Entgegenhaltungen:
- EP-A1- 1 586 940
- EP-A1- 2 738 600
- JP-A- H06 194 708
- US-A1- 2008 317 072
- QING-YANG XU ET AL: "Theoretical Analysis of Intra-Cavity Second-Harmonic Generation of Semiconductor Lasers by a Periodically Poled Nonlinear Crystal Waveguide", IEEE JOURNAL OF QUANTUM ELECTRONICS, IEEE SERVICE CENTER, PISCATAWAY, NJ, USA, vol. 47, no. 4, 1 April 2011 (2011-04-01), pages 462 - 470, XP011478511, ISSN: 0018-9197, DOI: 10.1109/JQE.2010.2091625
- E. U. RAFAILOV ET AL: "Efficient frequency doubling of a pulsed laser diode by use of a periodically poled KTP waveguide crystal with Bragg gratings", OPTICS LETTERS, vol. 26, no. 24, 15 December 2001 (2001-12-15), US, pages 1961, XP055664065, ISSN: 0146-9592, DOI: 10.1364/OL.26.001961
- SHINOZAKI K ET AL: "SELF-QUASI-PHASE-MATCHED SECOND-HARMONIC GENERATION IN THE PROTON-EXCHANGED LINBO3 OPTICAL WAVEGUIDE WITH PERIODICALLY DOMAIN-INVERTED REGIONS", APPLIED PHYSICS LETTERS, A I P PUBLISHING LLC, US, vol. 59, no. 5, 29 July 1991 (1991-07-29), pages 510 - 512, XP000233660, ISSN: 0003-6951, DOI: 10.1063/1.105422

## Beschreibung

Die vorliegende Erfindung betrifft eine Vorrichtung zur Erzeugung von Laserstrahlung. Insbesondere betrifft die vorliegende Erfindung eine effiziente Vorrichtung zur Erzeugung von Laserstrahlung mittels Frequenzverdoppelung.

### Stand der Technik

Mithilfe von sogenannten nichtlinearen Materialien, deren elektrische Polarisation nichtlinear auf ein externes elektrisches Feld reagiert, ist es möglich, Licht zu einer anderen Wellenlänge zu konvertieren (nichtlineare Frequenzkonversion). Beispiele für derartige Prozesse sind die Frequenzverdoppelung (Second Harmonic Generation, SHG) oder die parametrische Fluoreszenz (spontaneous parametric down conversion, SPDC). Es gibt verschiedenste Ausführungen für die konkrete Umsetzung, die jedoch im Grundprinzip und in den hier beschriebenen Eigenschaften ähnlich sind. Da die nichtlinearen Medien in der Regel von kristalliner Struktur sind, wird im Folgenden nur von Kristallen gesprochen. Es ist möglich, den Kristall als Volumenmaterial zu nutzen, wobei das Licht von der Quelle durch optische Elemente geeignet geformt wird, sodass ein bestimmtes Strahlprofil bzw. Kaustik im Kristall vorliegt. Ferner kann der Kristall auch Wellenleiterstrukturen enthalten, die das eingestrahlte und/oder das generierte Licht führen (Rippenwellenleiterstruktur, Kanalwellenleiter, etc.). Dazu muss das eingestrahlte Licht in diese Wellenleiterstruktur eingekoppelt werden. Auch Kombinationen aus beidem sind möglich, also Wellenleitung in einer Dimension und Volumenmaterial in der anderen Dimension (planare Wellenleiterstruktur).

Damit die nichtlinearen Prozesse möglichst effizient ablaufen, muss die so genannte Phasenanpassung zwischen den beteiligten Lichtstrahlen erfüllt werden.

Dazu gibt es zwei weit verbreitete Verfahren. Zum einen ist es möglich, doppelbrechende Eigenschaften der Kristalle auszunutzen, wobei eine genaue Ausrichtung der Lichtstrahlen und der kristallographischen Achsen des Kristalls notwendig wird. Durch die doppelbrechende Eigenschaft des Kristalls ändert sich so der Brechungsindex für das eingestrahlte und erzeugte Licht, je nach Winkel der Lichtstrahlen zu den kristallografischen Achsen.

Eine weitere Methode ist die Quasi-Phasenanpassung. Dabei wird der nichtlineare Kristall periodisch gepolt, sodass eine Schichtabfolge von wechselnder Orientierung der elektrischen Polarisation entlang der Strahlrichtung des eingestrahlten Lichtes vorliegt. Die Periode dieser Polung wird so gewählt, dass für den gewünschten nichtlinearen Prozess die Phasenanpassung erfüllt wird. Die optimale Polung hängt von der Art des Prozesses, der Wellenlänge des eingestrahlten Lichtes und den Brechungsindizes des Kristalls für die Wellenlänge des eingestrahlten Lichtes und der Wellenlänge des zu erzeugenden Lichtes ab. So kann beispielsweise die Periodizität der Polung so gewählt werden, dass eine effiziente Frequenzverdoppelung für genau eine Wellenlänge ermöglicht wird. Für eine andere Wellenlänge ist wiederum eine leicht andere Periodizität erforderlich.

Bei beiden Verfahren ist es erforderlich, sowohl die Wellenlänge des eingestrahlten Lichtes genau einzustellen als auch alle Kristallparameter, die auf die Phasenanpassung Einfluss haben, genau zu kontrollieren. Da gerade beim Kristall der Brechungsindex starken Einfluss auf die Phasenanpassung hat und dieser wiederum von der Kristalltemperatur abhängt, muss vor allem die Kristalltemperatur aktiv kontrolliert werden. Gerade für Gesamtsysteme, bestehend aus Laserquelle und Kristall, muss sowohl die Laserquelle als auch der Kristall durch Regelkreise einzeln kontrolliert werden.

Insbesondere bei Halbleiterlasern mit integrierter Wellenlängenstabilisation (z.B. Distributed-Bragg-Reflektor (DBR)) ändert sich die Emissionswellenlänge bei Variation der Ausgangsleistung oder der Temperatur. Bei diesen können sich sprunghafte Änderungen der Emissionswellenlänge ergeben (sogenannte Modensprünge). Die Wellenlängenänderung bei einem Modensprung hängt invers mit der Resonatorlänge eines Lasers zusammen. Im Fall von Halbleiterlasern mit typischen Resonatorlängen unterhalb eines Zentimeters kann die Wellenlängenänderung bis zu einigen zehn Pikometern betragen, was sich negativ auf den nichtlinearen Prozess auswirkt. Daher ergibt sich der Nachteil, dass beim Einsatz derartiger Laser eine aufwändige Regelungstechnik notwendig wird, um bei jedem Arbeitspunkt individuell Betriebsparameter des Lasers und/oder des Kristalls einzustellen. Hauptproblem ist die Tatsache, dass Laserquelle und Kristall für nichtlineare Prozesse zwei voneinander getrennte Baugruppen sind, die für sich genommen individuell gesteuert werden müssen.

Beim Einsatz von periodisch gepolten Kristallen ergeben sich darüber hinaus weitere Nachteile, die sich durch die periodische Polung ergeben. An den Grenzen der einzelnen Polungsschichten kommt es zu kleinen Änderungen des Brechungsindex, sodass an jeder dieser Domänengrenzen ein kleiner Teil des Lichtes reflektiert wird. Durch die periodische Anordnung der Polung wirkt der nichtlineare Kristall zudem wie ein Bragg-Gitter, das typische Resonanzmaxima bei bestimmten Wellenlängen aufweist. Die Lage dieser Resonanzen hängt von der Periodizität der Polung und dem Brechungsindex bei der jeweiligen Wellenlänge ab. Somit werden die Resonanzen durch die Wahl der periodischen Polung beeinflusst, es muss jedoch zwischen der Wellenlänge, für die die periodische Polung im Sinne eines effizienten nichtlinearen Prozesses optimiert wurde, und der Wellenlänge, bei der eine Resonanz auftritt, unterschieden werden. Da beide unterschiedliche Abhängigkeiten haben, gibt es Polungsperioden, die dazu führen, dass Resonanz und der effiziente nichtlineare Prozess bei der gleichen Wellenlänge auftreten. Umgekehrt können sie sich aber auch stark unterscheiden, wenn die Polungsperiode nur leicht variiert wird. Da insbesondere die Brechungsindizes mit der Temperatur variieren und die Resonanz sowie der nichtlineare Prozess unterschiedlich mit dem Brechungsindex skalieren, kann über die Temperatur in einem gewissen Rahmen eingestellt werden, ob beide Effekte bei derselben Wellenlänge auftreten.

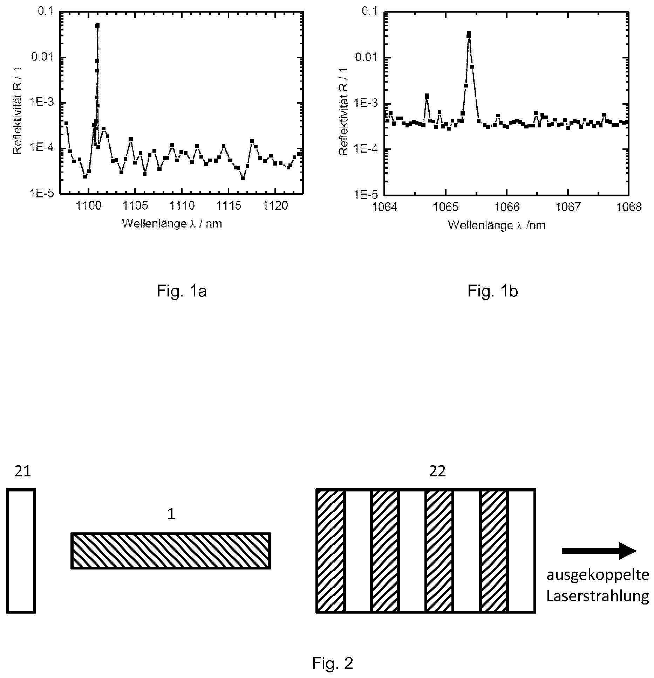

In Fig. 1 sind die Reflexionsspektren für zwei verschiedene periodisch gepolte Lithiumniobat-Kristalle bei einer Temperatur von 25°C gezeigt. In beiden Fällen handelt es sich um Kristalle mit Rippenwellenleiterstruktur, das heißt, das Licht wird in einem Rippenwellenleiter durch den Kristall geführt. Der Kristall aus Fig. 1a) ist für SHG bei einer Wellenlänge von 1122 nm optimiert. Die Bragg-Resonanz in dem beobachteten Wellenlängenbereich liegt jedoch bei 1100 nm. Bei dem Kristall aus Fig. 1b) handelt es sich um einen Kristall für SHG bei 1070 nm, während hier eine Bragg-Resonanz nur wenige Nanometer weniger bei 1065 nm auftritt. Gerade die intensiven Bragg-Resonanzen, die fast 10% des eingestrahlten Lichtes bei dieser Wellenlänge reflektieren, können die verwendete Lichtquelle erheblich im Betrieb stören, vor allem wenn die Resonanz nahe an der Wellenlänge für die nichtlineare Frequenzkonversion, also nahe der Emissionswellenlänge der Lichtquelle, liegt. Aber auch der beobachtete Rauschuntergrund abseits der Bragg-Resonanzen mit Reflektivitäten von 0,001% bis 0,1% kann für den stabilen Betrieb eines Lasers als Lichtquelle zum Problem werden.

Gerade Halbleiterlaser können teils stark auf Rückreflexe reagieren und als Folge abrupte Änderungen der Ausgangsleistung und ihrer spektralen Eigenschaften zeigen. Da die Frequenzkonversion es meist erfordert, dass die Wellenlänge in einem sehr engen Fenster stabil bleibt (Wellenlängenakzeptanz) und zudem stark von der eingestrahlten Leistung abhängt, ist es für einen zuverlässigen Betrieb unerlässlich, dass der Laser möglichst wenig von Rückreflexen beeinflusst wird.

Die grundlegende Erklärung des gestörten Betriebes der Laser unter Einfluss von Rückreflexen liegt darin, dass unterschiedliche Resonatoren miteinander konkurrieren. Zum einen der Resonator, der Bestandteil des Lasers ist (interner Resonator) und zum anderen jener der aus dem Laser und dem nichtlinearen Medium gebildet wird (externer Resonator). Auch hierbei liegt die Hauptursache darin, dass Laser und Kristall zwei individuelle Baugruppen sind und im Falle des Lasers auf externe Einflüsse reagieren.

Um dieses Problem zu lösen oder zumindest abzuschwächen, sind bislang verschiedene konventionelle Ansätze bekannt.

Mit einem optischen Isolator zwischen Laserquelle und nichtlinearem Medium lassen sich die Rückreflexe um mehrere Größenordnungen abschwächen, sodass der externe Resonator starke optische Verluste erfährt (die Resonatorgüte wird herabgesetzt) und der Laserbetrieb nicht mehr oder nur gering gestört wird. Der Einsatz eines optischen Isolators erhöht jedoch die Kosten und Komplexität eines Aufbaus. In Bezug auf die Mikrointegration besteht zudem das Problem, dass miniaturisierte optische Isolatoren nicht für alle Wellenlängen zur Verfügung stehen und zudem nicht für alle Leistungsklassen geeignet sind. Außerdem führen optische Isolatoren immer zu gewissen optischen Verlusten durch Absorption von Licht.

Als zweiter Ansatz kann der Laser optimiert werden, indem die Güte des internen Resonators erhöht wird, sodass dieser auch bei Rückreflexen bis zu einem gewissen Level einen stabilen Laserbetrieb aufweist. Bei Halbleiterlasern kann zum Beispiel die Frontfacettenreflektivität erhöht werden. Nachteilig dabei ist jedoch, dass in der Regel die maximale Ausgangsleistung der Laser reduziert wird. Je nach Lasertyp sind derartige Optimierungen bauartbedingt jedoch nicht möglich.

Der dritte Ansatz ist, den Kristall zu verändern, sodass die Rückreflexe verringert werden oder zumindest nicht mehr in den Laser gelangen können. Dies entspricht im Wesentlichen auch einer Verringerung der Güte des externen Resonators. Die periodische Polung kann so ausgeführt werden, dass die Domänengrenzen der Polung nicht mehr senkrecht zum eingestrahlten Strahl stehen. Rückreflexe können dabei zwar auftreten, der größte Leistungsanteil wird jedoch unter einem Winkel zurückgestrahlt, sodass diese die Laserquelle nicht erreichen. Nachteilig kann ein höherer Aufwand bei der Herstellung der periodischen Polung im Kristall und eine unter Umständen reduzierte Effizienz des nichtlinearen Prozesses sein. Darüber hinaus wird stets ein kleiner Teil des Lichtes trotzdem in Richtung Laserquelle reflektiert.

Der dritte Ansatz ist bereits im Stand der Technik bekannt, um die Reflexe an den Eintritts- und Austrittsfacetten des Kristalls von der Strahlquelle abzulenken. Trotz Antireflex-beschichtung liegt die Restreflektivität der Facetten typischerweise im Bereich 0,1 %. Die Facetten werden dabei so ausgeführt, dass die Lichtstrahlen einen Einfallswinkel von einigen Grad zur Facette haben.

Die herkömmlichen Vorrichtungen zur Frequenzverdopplung unter Verwendung nichtlinearer Kristalle führen daher entweder zu optischen Verlusten oder erfordern einen erhöhten Herstellungsaufwand. Darüber hinaus ist ein erhöhter Regelaufwand von Nöten, um die Betriebsparameter des Lasers und des Kristalls individuell zu kontrollieren.

US 2008/317072 A1, EP 2 738 600 A1, JP H06 194708 A,

QING-YANG XU ET AL: "Theoretical Analysis of Intra-Cavity Second-Harmonic Generation of Semiconductor Lasers by a Periodically Poled Nonlinear Crystal Waveguide", IEEE JOURNAL OF QUANTUM ELECTRONICS, Bd. 47, Nr. 4, 1. April 2011 (2011-04-01), Seiten 462-470, XP011478511,

E. U. RAFAILOV ET AL: "Efficient frequency doubling of a pulsed laser diode by use of a periodically poled KTP waveguide crystal with Bragg gratings", OPTICS LETTERS, Bd. 26, Nr. 24, 15. Dezember 2001 (2001-12-15), Seite 1961, XP055664065, und

SHINOZAKI K ET AL: "SELF-QUASI-PHASE-MATCHED SECONDHARMONIC GENERATION IN THE PROTON-EXCHANGED LINB03 OPTICAL WAVEGUIDE WITH PERIODICALLY DOMAIN-INVERTED REGIONS", APPLIED PHYSICS LETTERS,Bd. 59, Nr. 5, 29. Juli 1991 (1991-07-29), Seiten 510-512, XP000233660 offenbaren herkömmliche Vorrichtungen zur Frequenzverdopplung unter Verwendung nichtlinearer Kristalle. Aus EP 1 586 940 A1 ist eine Vorrichtung gemäß dem Oberbegriff des Anspruchs 1 bekannt.

### Offenbarung der Erfindung

Es ist daher eine Aufgabe der vorliegenden Erfindung, eine Vorrichtung zur Erzeugung von Laserstrahlung unter Verwendung eines nichtlinearen Kristalls anzugeben, die die vorgenannten Nachteile überwindet.

Diese Aufgaben werden erfindungsgemäß durch die Merkmale des unabhängigen Patentanspruchs 1 gelöst. Zweckmäßige Ausgestaltungen der Erfindung sind in den jeweiligen Unteransprüchen enthalten.

Gemäß einem Aspekt der vorliegenden Erfindung umfasst die Vorrichtung zur Erzeugung von Laserstrahlung einen optischen Verstärker mit einer aktiven Zone, wobei der optische Verstärker eine Frontfacette und eine Rückfacette aufweist, zwischen denen sich die aktive Zone erstreckt; und einen Resonator mit einem ersten Resonatorelement und einem zweiten Resonatorelement, zwischen denen sich der optische Verstärker erstreckt, wobei das erste Resonatorelement auf einer der Frontfacette abgewandten Seite der aktiven Zone und das zweite Resonatorelement auf einer der Frontfacette zugewandten Seite der aktiven Zone angeordnet ist, wobei das zweite Resonatorelement einen nichtlinearen Kristall mit einer periodischen Polung umfasst. Die periodische Polung ist aus einer Vielzahl einzelner periodisch angeordneter Polungsschichten gebildet und durch die Grenzen der Polungsschichten wird die Reflektivität des nichtlinearen Kristalls verursacht. Der optische Verstärker ist als elektrisch gepumpter optischer Halbleiter-Verstärker ausgebildet, wobei die aktive Zone zur Emission von Strahlung einer ersten Wellenlänge ausgebildet ist. Der nichtlineare Kristall ist dazu ausgebildet, Strahlung der ersten Wellenlänge mittels nichtlinearer Frequenzkonversion in Strahlung einer zweiten Wellenlänge zu konvertieren. Die Vorrichtung umfasst weiterhin einen Temperaturregelkreis, wobei der Temperaturregelkreis ausgebildet ist, den nichtlinearen Kristall in seiner Temperatur aktiv zu regeln, so dass die Temperatur des nichtlinearen Kristalls so angepasst wird, dass stets eine optimale Frequenzkonversion stattfindet, eine frequenzkonvertierte Strahlung also in ihrer Leistung maximal ist. Das Verhältnis der Reflektivität des Kristalls für die erste Wellenlänge ist größer als oder gleich 10 zur Reflektivität der Frontfacette für die erste Wellenlänge. Der optische Verstärker und der Kristall sind derart zueinander ausgerichtet, dass die vom optischen Verstärker emittierte Strahlung in eine Eintrittsfacette des Kristalls eingekoppelt wird, wobei die Grenzen von den periodisch angeordneten Polungsschichten des Kristalls senkrecht zur in den Kristall eingekoppelten Strahlung verlaufen, und wobei der nichtlineare Kristall keine strahlführenden Elemente umfasst.

Bei herkömmlichen Vorrichtungen wird der Resonator um das aktive Medium stets unabhängig vom Kristall gebildet. Im Falle von periodisch gepolten Kristallen wird stets versucht, die Güte des externen Resonators zu verringern oder die des internen Resonators (d.h. des optischen Verstärkers) zu erhöhen. Die Idee der vorliegenden Erfindung besteht darin, den Kristall als externen Resonatorspiegel gezielt zu nutzen. Dazu werden die bereits vorhandenen Rückreflexe, die durch einen Kristall mit periodischer Polung erzeugt werden, genutzt, insbesondere spektral selektive Rückreflexe, damit der periodisch gepolte Kristall als Resonatorspiegel dient.

Der für den Laserbetrieb notwendige Resonator um das Verstärkermedium (optischer Verstärker) wird dabei auf der Auskoppelseite der Laserstrahlung durch den Kristall selbst gebildet. Mit anderen Worten erreicht der optischer Verstärker gemäß einer Ausführungsvariante erst durch den Rückreflex der periodischen Polung des Kristalls die Laserschwelle.

Während ein Großteil der optischen Leistung (z.B. für die Frequenzverdopplung) durch den Kristall propagiert und für nichtlineare Prozesse genutzt werden kann, wird gleichzeitig ein Teil der Strahlung an den Domänengrenzen der periodischen Polung zurück zum optischen Verstärker reflektiert und stellt so den Laserbetrieb sicher.

Hinter dem optischen Verstärker befindet sich ebenfalls ein rückseitiger Resonatorspiegel (Resonatorelement). Um eine effiziente Ausnutzung des Rückreflexes des Kristalls zu realisieren, ist ein Verstärker gemäß einer Ausführungsvariante vorgesehen, bei dem die Reflektivität der Facette des optischen Verstärkers, die sich zwischen Verstärker und Kristall befindet (Frontfacette), in einem entsprechenden Verhältnis zur Reflektivität des Kristalls durch die periodische Polung bei der Betriebswellenlänge des Verstärkers eingerichtet ist. Das Verhältnis der Reflektivität Kristall (in Bezug auf die Betriebswellenlänge des Verstärkers) zur Reflektivität Frontfacette des Verstärkers (ebenfalls in Bezug auf die Betriebswellenlänge des Verstärkers) ist gleich oder größer größer als 10, und noch bevorzugter größer als 100.

Durch die gezielte Ausnutzung des Kristalls als externer Resonator ist der Kristall im Gesamtsystem sowohl für die Wellenlängenselektion als auch den nichtlinearen Prozess verantwortlich. Es genügt, nur den Kristall aktiv in z.B. der Temperatur zu regeln, d.h. die Temperatur muss durch einen Regelkreis so angepasst werden, dass stets die optimale Frequenzkonversion stattfindet, die frequenzkonvertierte Strahlung also in ihrer Leistung maximal ist. Der optische Verstärker muss gegebenenfalls nur passiv in der Temperatur geregelt werden, damit dieser die anfallende Verlustwärme abführen kann, was jedoch keinen aufwändigen Regelkreis erfordert. Dadurch, dass der externe Resonator länger als der interne Resonator des Verstärkers ist, fallen die Wellenlängenänderungen aufgrund von Modensprüngen deutlich geringer aus, sodass diese ebenfalls kein Problem mehr darstellen. Darüber hinaus ist es möglich, auf optische Isolatoren zwischen dem Verstärker und dem Kristall zu verzichten. Weiterhin ist es vorteilhafterweise nicht notwendig, die Reflektivität der Frontfacette des Verstärkers zur Unterdrückung etwaiger Rückreflexe zu erhöhen. Gemäß einer Ausführungsvariante kann eine Antireflexbeschichtung (oder sonstige Antireflexvorrichtungen) an der Eintrittsfacette des Kristalls verwendet werden.

Gemäß der Erfindung ist der optische Verstärker als elektrisch gepumpter optischer Halbleiter-Verstärker ausgebildet. Dabei ist die aktive Zone zur Emission von Strahlung einer ersten Wellenlänge ausgebildet (Betriebswellenlänge des Verstärkers). Weiterhin ist es gemäß einer Ausführungs-variante vorgesehen, dass der Resonator ausgebildet ist, die Intensität der Strahlung der ersten Wellenlänge innerhalb des Resonators bis über die Laserschwelle hinaus zu erhöhen, so dass Laserstrahlung der Betriebswellenlänge im Kristall konvertiert (Frequenzverdopplung) und zur weiteren Nutzung über eine Austrittsfacette des Kristalls ausgekoppelt werden kann. Der Kristall wirkt daher einerseits zur Ausbildung eines Resonators zur Erzeugung von Laserstrahlung unter Verwendung des elektrisch gepumpten Verstärkers und andererseits zur Erzeugung von Sekundärlaserstrahlung durch Frequenzkonversion der durch Verstärker und Resonator (Kristall) erzeugten Primärlaserstrahlung.

Gemäß der Erfindung ist das Verhältnis der Reflektivität des Kristalls durch die periodische Polung für die erste Wellenlänge zur Reflektivität der Frontfacette des Verstärkers für die erste Wellenlänge größer als 10, bevorzugter größer als 100 und noch bevorzugter größer als 500. Gemäß einer Ausführungsvariante der Erfindung ist die Reflektivität der Frontfacette des Verstärkers für die erste Wellenlänge kleiner als 0,001 (also kleiner als 0,1% bzw. kleiner als 10⁻³), bevorzugter kleiner als 10⁻⁴, noch bevorzugter kleiner als 10⁻⁵ und noch bevorzugter kleiner als 10⁻⁶.

Gemäß der Erfindung ist der nichtlineare Kristall ausgebildet, die vom Verstärker erzeugte Strahlung (der ersten Wellenlänge) mittels nichtlinearer Frequenz-konversion in Strahlung einer zweiten Wellenlänge zu konvertieren. Der Kristall ist ausgebildet, die über die Eintrittsfacette eingekoppelte Strahlung einem nichtlinearen Konversionsprozess zu unterziehen. Vorzugsweise beträgt die erste Wellenlänge das Doppelte der zweiten Wellenlänge. Dabei ist es bevorzugt, dass der Kristall zur Frequenzverdoppelung auf die Wellenlänge des Verstärkers angepasst ist. Mit anderen Worten ist es bevorzugt, dass der Kristall seine maximale Konversionseffizienz bei der ersten Wellenlänge besitzt. Alternativ zur Frequenzverdopplung kommen auch andere nichtlineare Konversionsprozesse, z.B. SPDC, in Betracht, für die Kristall und Verstärker in Bezug auf die jeweilige maximale Konversionseffizienz angepasst sind.

Vorzugsweise ist der nichtlineare Kristall mit der periodischen Polung derart ausgebildet, dass eine Differenz zwischen derjenigen Wellenlänge, für die der Kristall eine maximale Reflektivität besitzt, und derjenigen Wellenlänge, für die der Kristall eine maximale Konversionseffizienz besitzt, kleiner als 30 nm, bevorzugter kleiner als 25 nm, noch bevorzugter kleiner als 20 nm, noch bevorzugter kleiner als 15 nm, noch bevorzugter kleiner als 10 nm und noch bevorzugter kleiner als 5 nm ist.

Vorzugsweise ist die periodische Polung eine homogene periodische Polung. Hierbei bedeutet homogen, dass die Periodizität der Polung konstant über die gesamte Länge der periodischen Polung ist.

Vorzugsweise erstreckt sich die periodische Polung über die gesamte Länge des Kristalls.

Die Reflektivität des Kristalls wird durch die Domänengrenzen verursacht. Dabei haben die einzelnen Domänengrenzen über die Länge des Kristalls und auch über der Querschnittsfläche des Kristalls (zumindest der von dem geführten Licht eingenommenen Querschnittsfläche) eine gleichbleibende Reflektivität.

In Bezug auf die Wellenlängendifferenz lassen sich folgende drei Fälle unterscheiden.

Im ersten (weiter oben erläuterten) Fall ist der Kristall für eine Wellenlänge bei einer bestimmten Temperatur konzipiert, sodass Reflexionsmaximum und Wellenlänge für maximale Konversionseffizienz identisch sind.

Im zweiten Fall liegen die Wellenlängen etwas auseinander. In diesem Fall kann durch eine Änderung der Temperatur oder anderer Einflussgrößen dafür gesorgt werden, dass beide Wellenlängen übereinstimmen. Dabei verschiebt sich diese gemeinsame Wellenlänge jedoch leicht, was bei der Konzeption der Anordnung berücksichtigt wird. Außerdem ist dieses Verfahren stark von den Eigenschaften des Kristalls abhängig und in der Regel nur für kleine Wellenlängenabweichungen (vorzugsweise bis zu 5 nm) geeignet. Dies liegt daran, dass sich die Wellenlänge nur langsam mit der Temperatur ändert und man (rechnerisch) schnell zu Temperaturen kommt, die sich nicht sinnvoll umsetzen lassen, beispielsweise wenn - je nach Kristall und Verstärker - eine Differenz von 15 nm ausgeglichen werden soll.

Im dritten Fall ist der Wellenlängenunterschied noch größer, so dass eine Temperaturregelung (allein) ebenfalls nicht sinnvoll ist.

Es gibt jedoch dennoch die Möglichkeit, den Kristall als Resonatorspiegel zu verwenden.

Zum einen wird nicht die wellenlängenselektive Eigenschaft des scharfen Resonanzmaximums genutzt, sondern der eher homogene Rauschuntergrund bei zirka 0,1 % Reflektivität (siehe Figur 1a). Dabei ist jedoch ein zusätzliches wellenlängenselektives Element in den Resonator einzubringen, damit der Laserbetrieb durch dieses Element bei der Wellenlänge für den effektiven nichtlinearen Prozess stattfindet und nicht bei der Resonanzwellenlänge.

Gemäß einer Ausführungsvariante sind zwischen der Frontfacette des optischen Verstärkers und der Eintrittsfacette des Kristalls keine optischen Isolatoren bzw. keine optischen Filter angeordnet.

Gemäß der Erfindung weist der nichtlineare Kristall keine strahlführenden Elemente, wie einen Wellenleiter auf, wobei die vom optischen Verstärker emittierte (und in den Kristall zwecks Frequenzkonversion eingekoppelte) Strahlung senkrecht entlang der Domänengrenzen der periodischen Polung des Kristalls verläuft. Im Gegensatz zu einer Ausführungsvariante mit einem Kristall mit Wellenleiter ist die Reflektivität der periodischen Polung bei Kristallen ohne strahlführende Elemente geringer, weshalb eine senkrechte Anordnung der Domänengrenzen zur Strahlung ausgeführt ist.

Die Facetten des Kristalls sind vorzugsweise schräg zur Hauptrichtung der Strahlung im Kristall, da sonst durch die Facetten ein zusätzlicher Resonator gebildet wird, der wiederum den Laserbetrieb stören würde. Ein Winkel zwischen den Facetten des Kristalls und der im Kristall propagierenden Strahlung beträgt bevorzugt zwischen 1° und 10°, bevorzugter zwischen 2° und 5° (Vollkreis 360°).

Vorzugsweise weist der Verstärker einen Rippenwellenleiter auf. Gemäß einer Ausführungsvariante ist der Kristall aus Lithiumniobat ausgebildet.

Der rückseitige Resonatorspiegel kann gemäß einer Ausführungsvariante durch Integration eines Oberflächengitters in dem (dem Verstärker abgewandten) Ende bzw. hinteren Teil des Rippenwellenleiters ausgebildet werden. Dies ist insbesondere dann bevorzugt, wenn eine Differenz zwischen derjenigen Wellenlänge, für die der Kristall eine maximale Reflektivität besitzt, und derjenigen Wellenlänge, für die der Kristall eine maximale Konversionseffizienz besitzt, größer als 5 nm, bevorzugter größer als 10 nm und noch bevorzugter größer als 15 nm ist.

Alternativ ist es möglich, den rückseitigen Resonatorspiegel durch die Rückfacette des optischen Verstärkers auszubilden. Dies ist insbesondere dann bevorzugt, wenn eine Differenz zwischen derjenigen Wellenlänge, für die der Kristall eine maximale Reflektivität besitzt, und derjenigen Wellenlänge, für die der Kristall eine maximale Konversionseffizienz besitzt, kleiner als 10 nm, noch bevorzugter kleiner als 5 nm und noch bevorzugter kleiner als 3 nm ist.

### Kurzbeschreibung der Zeichnungen

Die Erfindung wird nachfolgend in Ausführungsbeispielen anhand der zugehörigen Zeichnung erläutert. Es zeigen:
- Fig. 1a und Fig. 1b: Reflexionsspektra zweier periodisch gepolter Rippenwellenleiterkristalle,
- Fig. 2: eine schematische Schnittdarstellung einer erfindungsgemäßen Vorrichtung zur Stabilisation eines optischen Verstärkers mithilfe von Reflexen eines periodisch gepolten Kristalls zur Frequenzkonversion,
- Fig. 3a: eine schematische Draufsicht einer Vorrichtung gemäß einer ersten Ausführungsvariante, die nicht Teil der Erfindung ist,
- Fig. 3b: eine schematische Seitenansicht (Schnittdarstellung) einer Vorrichtung gemäß der ersten Ausführungsvariante, und
- Fig. 3c: eine schematische Seitenansicht (Schnittdarstellung) einer Vorrichtung gemäß einer Ausführungsvariante der Erfindung, und
- Fig. 4: eine Schnittdarstellung des in den Figuren 3a und 3b gezeigten Halbleiterverstärkers.

### Ausführliche Beschreibung der Zeichnungen

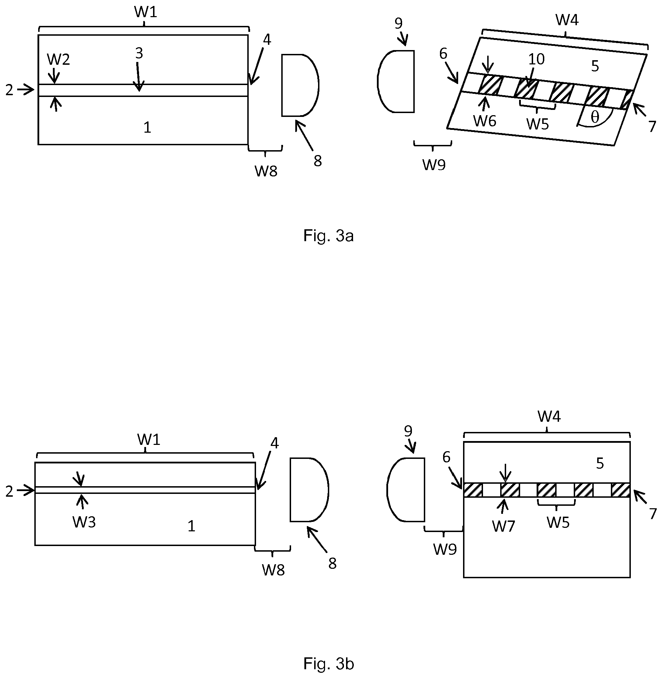

Fig. 3a und 3b zeigen eine Vorrichtung gemäß einer ersten Ausführungsvariante, die nicht Teil der Erfindung ist, in Draufsicht und seitlicher Schnittdarstellung, bei der ein periodisch gepolter Kristall mit Rippenwellenleiter als Resonatorspiegel für einen Halbleiterverstärker mit Rippenwellenleiterstruktur verwendet wird.

Der periodisch gepolte Kristall 5 weist die gleiche periodische Polung wie der Kristall, dessen Reflexionsspektrum in Fig. 1 b) gezeigt ist, auf, wobei die Domänen jedoch unter einem Winkel von θ = 92° zum Wellenleiter 10 angeordnet sind. Ziel ist es, das Reflexionsspektrum des Kristalls 5 zusätzlich als spektralen Filter zu verwenden und so die Emissionswellenlänge des Laserbetriebs bei 1065 nm festzulegen. Durch Variation der Temperatur des Kristalls und die unterschiedliche Skalierung der Bragg-Resonanzen und der Phasenanpassung für die Frequenzverdoppelung lässt sich schließlich die Emissionswellenlänge des Lasers so einstellen, dass das Licht beim Durchtritt durch den Kristall 5 optimal zur frequenzverdoppelten Strahlung umgesetzt wird (SHG).

Der Halbleiterverstärker 1 wurde mittels metallorganischer Gasphasenepitaxie auf Galliumarsenid (GaAs) prozessiert. Der Verstärker 1 hat eine Länge von W1 = 4 mm und eine Breite des Rippenwellenleiters 3 von W2 = 4 µm. In vertikaler Richtung ist ein W3 = 4,8 µm dicker Schichtwellenleiter ausgeführt. Die Rückfacette 2 ist verspiegelt und stellt somit den hinteren Resonatorspiegel (21 in Fig. 2) dar. Die Frontfacette 4 besitzt eine Antireflexbeschichtung und hat eine Reflektivität von weniger als 0,01 % für die Betriebswellenlänge von 1065 nm.

Der periodisch gepolte Kristall 5 besteht aus Lithiumniobat und ist beispielsweise kommerziell von der Firma HC Photonics Corp. erhältlich. Der Kristall 5 hat eine Länge von W4 = 10 mm, während die Periode der periodischen Polung W5 etwa 6,6 µm beträgt. Die Domänen der periodischen Polung sind gegenüber des Wellenleiters unter einem Winkel von θ = 92° angeordnet. Der Rippenwellenleiter 10 hat eine Breite W6 von etwa 6 µm und eine Höhe von W7 = 4 µm. Obwohl die Rippenwellenleiter 3, 10 von Verstärker 1 und Kristall 5 leicht unterschiedliche Dimensionen aufweisen, stimmen die in ihnen geführten Grundmoden (also bei zirka 1065 nm) in hohem Maße überein. Zur optischen Kopplung beider Komponenten kommen daher zwei asphärische Linsen 8 und 9 mit 4 mm Brennweite zum Einsatz. Diese werden jeweils so positioniert, dass der Abstand W8 zur Frontfacette 4 des Verstärkers 1 bzw. der Abstand W9 zur Eintrittsfacette 6 des Kristalls 5 der effektiven Brennweite der Linsen 8 und 9 entspricht. Der Abstand zwischen den beiden Linsen 8, 9 kann bis zu mehrere Meter betragen, solange er nicht in die Größenordnung der Rayleigh-Länge des zu koppelnden Laserstrahls kommt. Diese ist für gewöhnlich im Bereich größer als 1 m, bei Verwendung der Linsen mit 4 mm Brennweite.

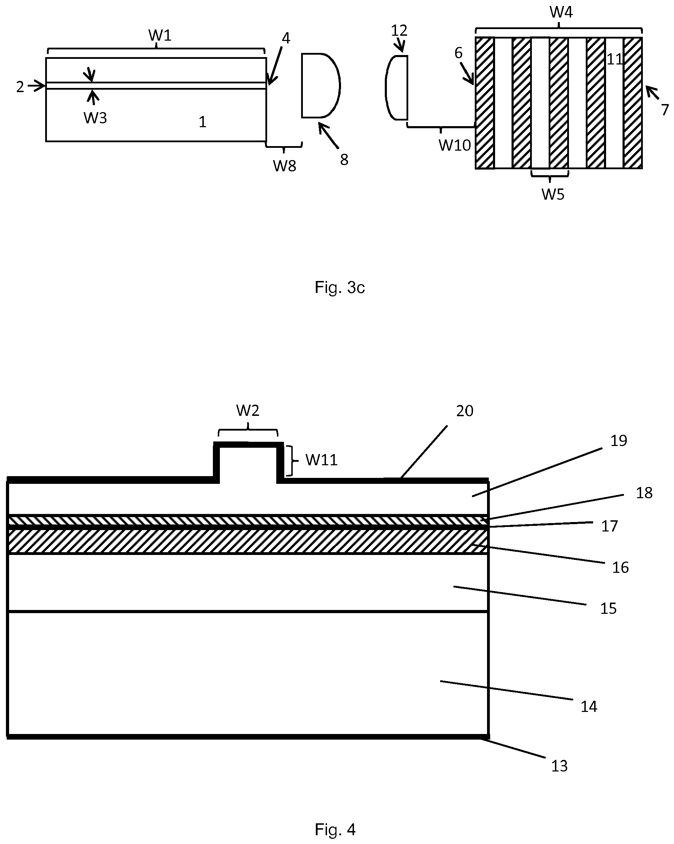

Der Kristall 11 der in Fig. 3c dargestellten Ausführungsvariante der Erfindung besitzt im Vergleich zum Kristall 5 keine strahlführenden Elemente und die eingekoppelte Strahlung propagiert daher frei durch den Kristall hindurch. Für die Einkopplung wird daher eine Linse 12 verwendet, die von der Linse 9 verschieden ist.

Der vertikale Schichtaufbau des Halbleiterverstärkers 1 ist in Fig. 4 gezeigt. Auf einem GaAs Substrat 14 ist die epitaktische Schichtfolge aufgebracht. Ein InGaAs-Trippelquantengraben bildet die aktive Zone 17, die asymmetrisch in einen Wellenleiter eingebracht ist. Der Wellenleiter setzt sich aus einem n-dotierten AlGaAs Wellenleiterkern 16 mit 4000 nm Dicke und einem p-dotierten AlGaAs Wellenleiterkern 18 mit 800 nm Dicke zusammen. So ergeben sich die insgesamt 4,8 µm, die in Fig. 3b als W3 angegeben sind. Der Wellenleiter ist von jeweils einer n-dotierten Mantelschicht 15 mit 500 nm Dicke und einer p-dotierten Mantelschicht 19 mit einer Dicke von 500 nm umgeben.

Der Rippenwellenleiter 3, welcher durch Ätzen erstellt wird, steht nochmals mit der Höhe W11 von 800 nm über die Mantelschicht 19 hinaus. Die elektrische Kontaktierung wird schließlich durch den p-Kontakt 20 und den n-Kontakt 13 gewährleistet.

Da die Bragg-Resonanzen des Kristalls 5 teilweise mehrere 10 nm von der optimalen Wellenlänge für die Frequenzverdopplung entfernt liegen, ist es nicht immer möglich, die Bragg-Resonanzen als wellenlängenselektives Element zu nutzen und gleichzeitig optimale Bedingungen für die Frequenzkonversion zu erreichen. Dennoch kann die nicht verschwindende Reflektivität von mindestens etwa 0,01% des Kristalls durch die periodische Polung zur Erreichung der Laserschwelle genutzt werden. Die Frontfacette 4 des Verstärkers muss hierbei sehr stark entspiegelt sein und weist eine Reflektivität von 10⁻⁶ oder kleiner auf. Hierbei fungiert der Kristall 5 wieder als vorderer Resonatorspiegel 22, jedoch ohne wellenlängenselektive Wirkung. Um dennoch die Emissionswellenlänge festzulegen, muss der hintere Resonatorspiegel 21 als wellenlängenselektives Element ausgeführt sein. Eine mögliche Ausgestaltung ist die Integration eines Oberflächengitters direkt in den hinteren Teil des Rippenwellenleiters 3.

### Bezugszeichenliste

- 1: optischer Verstärker
- 2: Rückfacette
- 3: Rippenwellenleiter
- 4: Frontfacette
- 5: optischer Kristall (periodisch gepolt)
- 6: Eintrittsfacette
- 7: Austrittsfacette
- 8: Linse
- 9: Linse
- 10: Rippenwellenleiter (Kristall)
- 11: optischer Kristall (periodisch gepolt ohne strahlführende Elemente)
- 12: Linse
- 13: n-Kontakt
- 14: Substrat
- 15: n-leitende Mantelschicht
- 16: n-leitende Kernschicht
- 17: aktive Zone
- 18: p-leitende Kernschicht
- 19: p-leitende Mantelschicht
- 20: p-Kontakt
- 21: rückseitiger Resonatorspiegel (erstes Resonatorelement)
- 22: vorderseitiger Resonatorspiegel (zweites Resonatorelement)

## Patentansprüche

1. Vorrichtung zur Erzeugung von Laserstrahlung, umfassend:
a) einen optischen Verstärker (1) mit einer aktiven Zone (17);
b) wobei der optische Verstärker (1) eine Frontfacette (4) und eine Rückfacette (2) aufweist, zwischen denen sich die aktive Zone (17) erstreckt; und
c) einen Resonator mit einem ersten Resonatorelement (21) und einem zweiten Resonatorelement (22), zwischen denen sich der optische Verstärker (1) erstreckt, wobei das erste Resonatorelement (21) auf einer der Frontfacette (4) abgewandten Seite der aktive Zone (17) und das zweite Resonatorelement (22) auf einer der Frontfacette (4) zugewandten Seite der aktive Zone (17) angeordnet ist,
wobei das zweite Resonatorelement (22) einen nichtlinearen Kristall (5, 11) mit einer periodischen Polung (W5) umfasst, wobei die periodische Polung (W5) aus einer Vielzahl einzelner periodisch angeordneter Polungsschichten gebildet ist, und wobei durch die Grenzen der Polungsschichten die Reflektivität des nichtlinearen Kristalls (5, 11) verursacht wird,
wobei der optische Verstärker (1) als elektrisch gepumpter optischer Halbleiter-Verstärker (1) ausgebildet ist, wobei die aktive Zone (16) zur Emission von Strahlung einer ersten Wellenlänge ausgebildet ist,
wobei der optische Verstärker (1) und der Kristall (5) derart zueinander ausgerichtet sind, dass die vom optischen Verstärker (1) emittierte Strahlung in eine Eintrittsfacette (6) des Kristalls (5) eingekoppelt wird,
wobei die Grenzen von den periodisch angeordneten Polungsschichten des Kristalls (11) senkrecht zur in den Kristall (11) eingekoppelten Strahlung verlaufen, und
wobei der nichtlineare Kristall (5,11) ausgebildet ist, Strahlung der ersten Wellenlänge mittels nichtlinearer Frequenzkonversion in Strahlung einer zweiten Wellenlänge zu konvertierten,
dadurch charakterisiert,
dass das Verhältnis der Reflektivität des Kristalls (5) für die erste Wellenlänge zur Reflektivität der Frontfacette (4) für die erste Wellenlänge größer oder gleich als 10 ist,
dass der nichtlineare Kristall (11) keine strahlführenden Elemente umfasst, und
dass die Vorrichtung weiterhin einen Temperaturregelkreis umfasst, wobei der Temperaturregelkreis ausgebildet ist, den nichtlinearen Kristall (5, 11) in seiner Temperatur aktiv zu regeln, so dass die Temperatur des nichtlinearen Kristalls (5, 11) so angepasst wird, dass stets eine optimale Frequenzkonversion stattfindet, die frequenzkonvertierte Strahlung der zweiten Wellenlänge also in ihrer Leistung maximal ist.

2. Vorrichtung nach Anspruch 1, wobei das Verhältnis der Reflektivität des Kristalls (5) für die erste Wellenlänge zur Reflektivität der Frontfacette (4) für die erste Wellenlänge größer oder gleich als 100 ist.

3. Vorrichtung nach einem der vorhergehenden Ansprüche, wobei eine Reflektivität der Frontfacette (4) für die erste Wellenlänge kleiner als 0,001 ist.

4. Vorrichtung nach einem der vorhergehenden Ansprüche, wobei die erste Wellenlänge das Doppelte der zweiten Wellenlänge beträgt.

5. Vorrichtung nach einem der vorhergehenden Ansprüche, wobei zwischen der Frontfacette (4) des optischen Verstärkers (1) und einer Eintrittsfacette (6) des Kristalls (5, 11) keine optischen Isolatoren und/oder keine optischen Filter angeordnet sind.

6. Vorrichtung nach einem der vorhergehenden Ansprüche, wobei die periodische Polung (W5), eine homogene periodische Polung ist.

7. Vorrichtung nach einem der vorhergehenden Ansprüche, wobei sich die periodische Polung (W5) über die gesamte Länge des Kristalls (5, 11) erstreckt.

## Claims

1. Device for generating laser radiation, comprising:
a) an optical amplifier (1) with an active zone (17);
b) wherein the optical amplifier (1) has a front facet (4) and a rear facet (2) between which the active zone (17) extends; and
c) a resonator comprising a first resonator element (21) and a second resonator element (22), between which the optical amplifier (1) extends, wherein the first resonator element (21) is arranged on a side of the active zone (17) facing away from the front facet (4) and the second resonator element (22) is arranged on a side of the active zone (17) facing the front facet (4),
wherein the second resonator element (22) comprises a nonlinear crystal (5, 11) with a periodic polarization (W5), wherein the periodic polarization (W5) is formed from a plurality of individual periodically arranged polarization layers, and wherein the reflectivity of the nonlinear crystal (5, 11) is caused by the boundaries of the polarization layers,
wherein the optical amplifier (1) is configured as an electrically pumped optical semiconductor amplifier (1), wherein the active zone (16) is configured to emit radiation of a first wavelength,
wherein the optical amplifier (1) and the crystal (5) are aligned with each other such that the radiation emitted by the optical amplifier (1) is coupled into an entrance facet (6) of the crystal (5),
wherein the boundaries of the periodically arranged polarizing layers of the crystal (11) are perpendicular to the radiation coupled into the crystal (11), and
wherein the nonlinear crystal (5, 11) is configured to convert radiation of the first wavelength into radiation of a second wavelength by means of nonlinear frequency conversion,
**characterized in that**
the ratio of the reflectivity of the crystal (5) for the first wavelength to the reflectivity of the front facet (4) for the first wavelength is greater than or equal to 10,
the nonlinear crystal (11) does not include any beam-guiding elements, and
the device further comprises a temperature control loop, the temperature control loop being configured to actively control the temperature of the nonlinear crystal (5, 11) so that the temperature of the nonlinear crystal (5, 11) is adapted so that optimal frequency conversion always takes place, so that the frequency-converted radiation of the second wavelength is at its maximum power.

2. The device according to claim 1, wherein the ratio of the reflectivity of the crystal (5) for the first wavelength to the reflectivity of the front facet (4) for the first wavelength is greater than or equal to 100.

3. The device according to any one of the preceding claims, wherein the reflectivity of the front facet (4) for the first wavelength is less than 0.001.

4. The device according to any one of the preceding claims, wherein the first wavelength is twice the second wavelength.

5. The device according to any one of the preceding claims, wherein no optical insulators and/or optical filters are arranged between the front facet (4) of the optical amplifier (1) and an entrance facet (6) of the crystal (5, 11).

6. The device according to any one of the preceding claims, wherein the periodic polarization (W5) is a homogeneous periodic polarization.

7. The device according to any one of the preceding claims, wherein the periodic polarization (W5) extends over the entire length of the crystal (5, 11).

## Revendications

1. Dispositif de génération de rayonnement laser, comprenant :
a) un amplificateur optique (1) comportant une zone active (17) ;
b) l'amplificateur optique (1) présentant une facette avant (4) et une facette arrière (2) entre lesquelles s'étend la zone active (17) ; et
c) un résonateur avec un premier élément de résonateur (21) et un deuxième élément de résonateur (22), entre lesquels s'étend l'amplificateur optique (1), le premier élément de résonateur (21) étant disposé sur un côté de la zone active (17) opposé à la facette avant (4) et le deuxième élément de résonateur (22) étant disposé sur un côté de la zone active (17) tourné vers la facette avant (4),
le deuxième élément de résonateur (22) comprenant un cristal non linéaire (5, 11) à polarisation périodique (W5), la polarisation périodique (W5) étant formée d'une pluralité de couches de polarisation périodiquement disposées, les limites des couches de polarisation générant la réflectivité du cristal non linéaire (5, 11),
l'amplificateur optique (1) étant conçu comme un amplificateur optique (1) à semiconducteur à pompage électrique, la zone active (16) étant conçue pour émettre un rayonnement d'une première longueur d'onde,
l'amplificateur optique (1) et le cristal (5) étant alignés l'un par rapport à l'autre de sorte que le rayonnement émis par l'amplificateur optique (1) soit couplé dans une facette d'entrée (6) du cristal (5),
les limites des couches de polarisation périodiquement disposées du cristal (11) s'étendant perpendiculairement au rayonnement couplé dans le cristal (11), et
le cristal non linéaire (5, 11) étant conçu pour convertir le rayonnement de la première longueur d'onde en rayonnement d'une deuxième longueur d'onde au moyen d'une conversion de fréquence non linéaire,
**caractérisé en ce que**
le rapport entre la réflectivité du cristal (5) pour la première longueur d'onde et la réflectivité de la facette avant (4) pour la première longueur d'onde est supérieur ou égal à 10,
le cristal non linéaire (11) ne comprend pas d'éléments de guidage de faisceau, et
le dispositif comprend en outre un circuit de régulation de température, le circuit de régulation de température étant conçu pour réguler activement la température du cristal non linéaire (5, 11) de manière à ce que la température du cristal non linéaire (5, 11) soit ajustée afin qu'une conversion de fréquence optimale ait toujours lieu, le rayonnement converti de la seconde longueur d'onde étant ainsi maximal en puissance.

2. Dispositif selon la revendication 1, dans lequel le rapport entre la réflectivité du cristal (5) pour la première longueur d'onde et la réflectivité de la facette avant (4) pour la première longueur d'onde est supérieur ou égal à 100.

3. Dispositif selon l'une des revendications précédentes, dans lequel la réflectivité de la facette avant (4) pour la première longueur d'onde est inférieure à 0,001.

4. Dispositif selon l'une des revendications précédentes, dans lequel la première longueur d'onde est le double de la deuxième longueur d'onde.

5. Dispositif selon l'une des revendications précédentes, dans lequel aucun isolateur optique et/ou aucun filtre optique n'est disposé entre la facette avant (4) de l'amplificateur optique (1) et une facette d'entrée (6) du cristal (5, 11).

6. Dispositif selon l'une des revendications précédentes, dans lequel la polarisation périodique (W5) est une polarisation périodique homogène.

7. Dispositif selon l'une des revendications précédentes, dans lequel la polarisation périodique (W5) s'étend sur toute la longueur du cristal (5, 11).
